## Europäisches Patentamt
## European Patent Office
## Office européen des brevets

(11) Publication number: **0 154 798**
**A1**

(12) ## EUROPEAN PATENT APPLICATION

(21) Application number: **85101075.1**

(22) Date of filing: **01.02.85**

(51) Int. Cl.⁴: **G 06 F 12/06, G 11 C 8/00**

(30) Priority: **02.03.84 IT 8333184**

(71) Applicant: **ZELTRON ISTITUTO ZANUSSI PER L'ELETTRONICA S.P.A., Via Giardini Cattaneo 3, I-33170 Pordenone (IT)**

(43) Date of publication of application: **18.09.85 Bulletin 85/38**

(72) Inventor: **Nadalutti, Gianfranco, Via della Chiesa 21, I-33040 Moimacco Udine (IT)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(84) Designated Contracting States: **AT BE CH DE FR GB IT LI LU NL SE**

(54) **Memory chip for handling memory components.**

(57)   Memory chip having a capacity of 64K words of 24 data bits and 6 memory error correction bits, the internal logic/memory timing buffer of said chip comprising a block (MPX) for generating a supplementary address (ADD7) which is supplied to the address buffer for handling 64K × 1 bit components by way of an address bus adapted to 16K components, said chip comprising 64K × 1 bit memory components.

## Memory Chip for Handling Memory Components

The object of the present invention a memory chip for handling memory components. More precisely, the present invention relates to a memory chip handling 64 K word memory components by employing a bus adapted for 16 K word components.

In particular, but not exclusively, a chip of this type is destined for equipping electronic component testing machinery. By way of example, electronic component testing machinery is made by Fairchild (USA) and marketed under the designation Sentry 10/20/21.

The chips according to the invention may be employed as original chips or in exchange for original chips with which such machinery is equipped, the chips according to the invention being compatible with the original chips and interchangeable therewith without any modification.

At present, memory chips of the type in question are normally used in groups of two chips each.

Each of these chips has a capacity of 64 K words. They are in the form of random access memories, i.e. RAM circuits having a capacity of 64 K words comprised of 24 data bits and 6 memory error correction bits or ECC bits, that is, a total of 30 bits per word.

The memory chip according to the invention permits to obtain the functionality of present chips or circuits with the number of components being reduced to about one quarter of that of the components of present circuits. Such present circuits employ 120 memories of 16 K x 1 bit with triple alimentation.

The chip or circuit according to the invention, in contrast, employs 30 components of 64 K x 1 bit for obtaining the same memory capacity.

In this manner , the chip or circuit is considerably simplified, more reliable and less expensive than the present circuit.

The reduction of the employed number of components in fact results in a reduced probability of failures, and in addition, in a considerable reduction of the energy demand of the circuit as a whole.

It is thus a further object of the invention to provide a chip or circuit of the type specified, which is immediately interchangeable with presently used circuits without requiring the hardware of the machinery to be modified in any manner.

As a matter of fact, a known circuit produced by the firm of Kmega (Switzerland) is capable of performing analogous functions, requiring, however, a modification of the hardware of the machine in which it is to be installed. The immediate interchangeability of the circuit is thus not achieved.

This known Kmega circuit employs 60 memories of 64 K x 1 bit for an overall capacity of 128 K.

With the novel circuit according to the invention it is thus intended to overcome the inherent limitations encountered with the employ of circuits or chips requiring modification of the hardware of an existing machine, and at the same time, as already stated, to reduce the number of components to about one quarter of the number formerly employed. As already stated, the circuit according to the invention uses 30 memory components instead of the 120 memory compon-

0154798

ents of prior art circuits for obtaining the same overall capacity. This is made possible by employing memory components of 64 K x 1 bit.

For the handling or management of such components, the invention provides for the employ of a known bus adapted for 16 K components. The memory chip according to the invention thus involves the employ of a 16 K bus for addressing a 64 K memory by creating, by means of a temporary phase shift of a suitable signal, a supplementary line or column address to be supplied to the memory component.

This supplementary address, which may be a line address or a column address, depending on a high or low value of a suitable signal contributing to its generation, is obtained by means of a novel functional logic. According to the invention, there is thus introduced a temporary delay for controlling a multiplexer or commutator effective to assign the significance of the thus generated supplementary address to this novel signal.

This supplementary address may assume the significance of a line address or a column address, as already mentioned.

As a matter of fact, the handling or management of 64 K memory components requires 16 addresses, i. e. 8 line addresses and 8 column addresses. If the employed memory components have only 8 address terminals, the required 16 addresses have to be in two blocks of 8 addresses each, so that for having 16 addresses in memory components of this type, it is necessary to supply 8 addresses at one instant, and the other 8 addresses at another instant.

Addressing a 16 K memory requires 7 line addresses and 7 column addresses, this being common prior art practice.

According to the invention it is possible, by delaying a line access signal, to generate a new address, which may be a line adress or a column address, depending on the high or low value of the delayed signal. These supplementary addresses are necessary, as already said, for being able to address a 64 K memory.

In this manner the supplementary line and column addresses are obtained without any modification of the hardware of the machine.

The present invention thus provides for the employ of a commutator or multiplexer controlled by a delayed line access signal for supplying a new address designated as a supplementary line or column address.

According to the known configuration of the prior art circuit, the 64 K memory comprises four 16 K memory banks in the form of physically separate components.

This arrangement is compatible with the use of a 16 K bus. In the known circuit, an Up/Low signal combined with control signals decides which of the four 16 K memory banks is to be selected. This selection is not necessary, however, in the case of the 64 K components according to the invention.

According to the invention, the Up/Low signal is not used as a memory bank selection signal, but as a signal for creating the supplementary address.

The Up/Low signal, in combination with one of the mentioned control signals supplied by the CPU (central processing unit), is effective to originate the supplementary address signal.

The present invention thus provides a memory chip, particularly, but not exclusively a memory chip for electronic component testing systems, said chip having a capacity of 64 K words of 24 data bits and 6 memory error correction bits, and comprising a main memory bank, an error correction memory bank, an internal logic/memory timing buffer for handling signals provenient from the CPU, an address buffer, and a data I/O buffer, and being characterized in that said internal logic//memory timing buffer comprises a section generating a supplementary address which is supplied to the address buffer for handling 64 K x 1 bit memory components via an address bus adapted for 16 K components, said chip presenting 64 K x 1 bit memory components.

An embodiment of the invention shall now be described by way of a non-limiting example with reference to the accompanying drawings, wherein:

fig. 1 shows a block circuit diagram of a circuit according to the invention,

fig. 2 shows a detail relating to the generation of the supplementary line and column addresses, and

figs. 3, 4, and 5 show diagrams of the reading cycle, of the writing cycle, and of the memory updating cycle, respectively.

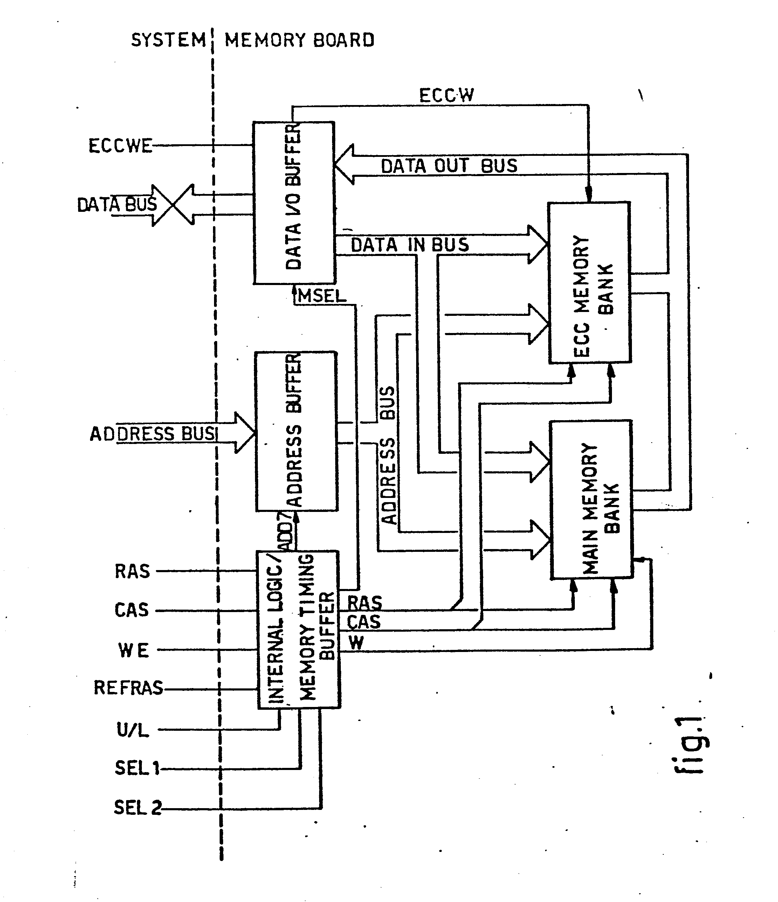

Shown in fig. 1 are the functional blocks constituting a circuit according to the invention.

A MAIN MEMORY BANK constitutes the central core of the circuit, the function assigned to which is the storage of the data supplied to the memory by the central processing unit CPU. In the embodiment shown, this memory block comprises 24 components of 64 K x 1 bit each. These components are advantageously in the form of dynamic RAMs designed for instance in H-MOS technology with single-shot input.

The total arrangement comprises an overall capacity of 64 K. Associated to each location of the MAIN MEMORY BANK is a secondary location of a ECC MEMORY BANK block. This block is an ECC memory block, that is to say, a block configured for the correction of memory errors.

These secondary locations contained in the ECC MEMORY BANK in fact serve the function of retaining a 6 bit code required by the CPU for the detection and correction of memory errors in the MAIN MEMORY BANK.

For maintaining the stored data over a period of time, the contents of each locations of both said memory blocks is updated at regular intervals in a per se known manner, these intervals being of a magnitude of about 2 ms in the present example.

The DATA I/O BUFFER block serves as an interface between the data bus of the system pertaining to the machine and the internal data bus of the memory circuit.

This buffer is of the bidirectional type, permitting the transition of data from the CPU to the memory and vice versa. The direction of the data transfer from the CPU to the memory, or from the memory to the CPU, respectively, is conditioned by the signal MSEL from the DATA I/O BUFFER after having been generated by the INTERNAL LOGIC/ /MEMORY TIMING BUFFER block.

The ADDRESS BUFFER block transfers the addresses provenient from the CPU to the internal address bus of the memory circuit. This buffer is of the unidirectional type, permitting the transfer of the addresses only from the system to the memory circuit by way of the ADDRESS BUS. These addresses are assigned either to the MAIN MEMORY BANK or to the ECC MEMORY BANK.

The INTERNAL LOGIC/MEMORY TIMING BUFFER block governs the signals supplied by the control bus.

In particular, it receives a series of signals from the CPU or central programming unit pertaining to the machine in which the circuit according to the invention is employed.

These signals shall be briefly described as follows: RAS and CAS are line access signals and column access signals, respectively. These signals are distributed to the memory components MAIN MEMORY BANK and ECC MEMORY BANK for each reading or writing cycle.

The signal WE enables the writing in the main bank and becomes the signal W distributed to the MAIN MEMORY BANK. Analogously to this signal WE received by the INTERNAL LOGIC block, the DATA I/O BUFFER block receives the signal ECCWE which becomes the ECCW writing signal applied to the ECC MEMORY BANK block.

The signal REFRAS controls the periodic updating of the memory (cf. fig. 5).

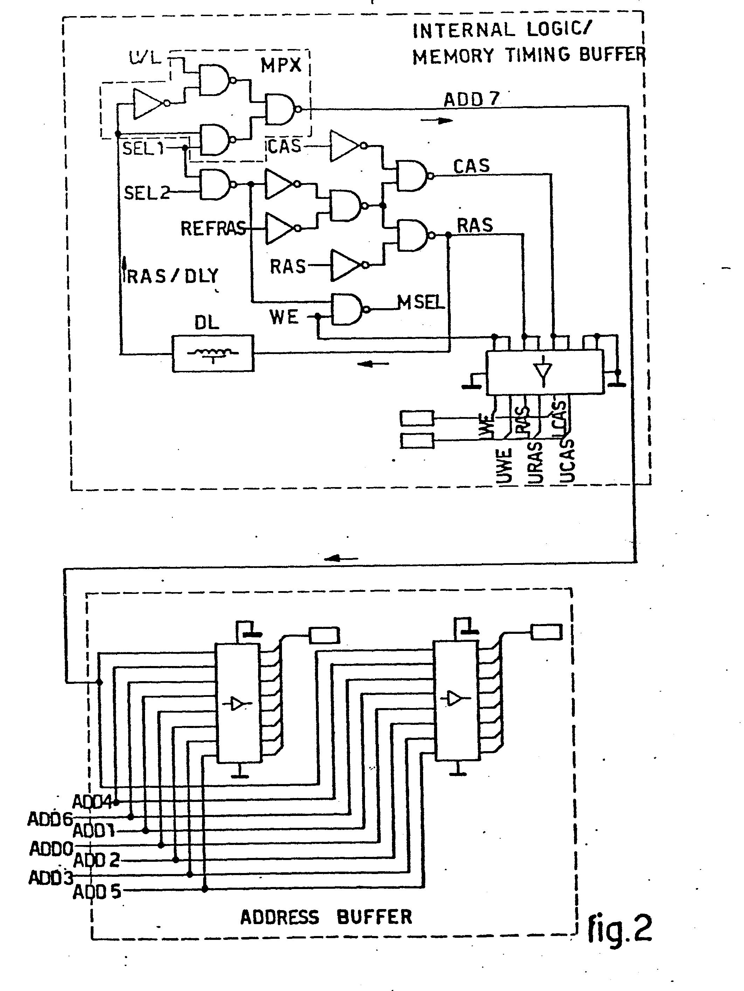

The signals SEL1 and SEL2 are control signals enabling memory to carry out input/output operations, as will be described in detail hereinafter. In particular, the signal SEL1 serves for generating the supplementary address ADD7 (cf. fig. 2) necessary for the 64 K components.

This supplementary address ADD7, which is added to the preceding addresses (indicated progressively by the reference designations ADD0 to ADD6, i.e. the 7 addresses already employed in prior art), serves for creating a new line address and a new column address, so as to obtain 8 line addresses and 8 column addresses. This is to the purpose of managing the 64 K components, as already stated in the preceding.

The signal SEL1 is employed in unison with an U/L signal employed as a bank address in the known circuit. As a matter of fact, in the known memory circuit the U/L (Up/Low) signal is employed for the selection of the appropriate bank, there being 4 banks of 16 K each in a 64 K memory.

In the known circuit, these banks are in the form of separate components, as already described above.

As the 64 K components in the circuit according to the invention each constitute a single bank, it is not necessary to employ the U/L signal as a memory bank selection signal. The U/L signal is employed instead, according to the invention, for generating the supplementary address ADD7 required for the management of the 64 K components.

The signals U/L and SEL1 are commutated in relation to the state of the signal RAS/DLY which is obtained by delaying the signal RAS advantageously by a delay value in the range of 70 to 120 nanoseconds.

The inventor has found a delay value of 100 ns to be the optimum with regard to the generation of the described signals as well as with regard to the availability of components adapted to introduce the desired delay.

In this manner, i.e. by generating the delayed signal RAS/DLY, it is possible to employ the data bus adapted to 16 K components for managing 64 K components.

The 16 K ADDRESS BUS is employed for assigning the first 7 + 7 line and column addresses, respectively, and in addition, with the aid of the RAS/DLY signal, for handling the two additional line and column addresses.

After having been delayed in the described manner, the signal RAS enables the MPX block (fig. 2) to commutate the signals U/L and SEL1, this commutation being effective to assign the required line address and column address functions, respectively, to the supplementary address.

Shown in greater detail in fig. 2 is the interrelation between the INTERNAL LOGIC/MEMORY TIMING BUFFER block and the ADDRESS BUFFER block.

With respect to the ADDRESS BUFFER, there are shown the first seven addresses ADD0 to ADD6 employed in prior art for handling 16 K components.

Also shown in fig. 2 is an additional address ADD7 supplied to the ADDRESS BUFFER after having been generated by an MPX block which takes the form of a commutator or multiplexer. This MPX block receives the signals U/L and SEL1 from the CPU and generates the address ADD7 for supply to the ADDRESS BUFFER. This Address ADD7 is generated by controlling the commutator MPX with the signal RAS/DLY.

RAS/DLY is obtained by delaying the signal RAS by means of the delay block DL. The supplementary address ADD7 is thus generated in the following manner:

The signal RAS, delayed by a predetermined value, in the present example by 100 ns, becomes the signal RAS/DLY which controls the commutator or multiplexer MPX in such a manner that the signal U/L or SEL1 appears at its output. If RAS/DLY is high, the commutator MPX outputs SEL1; if RAS/DLY is low, the commutator MPX outputs U/L.

By thus controlling the commutator MPX to initially supply the output signal SEL1 (RAS/DLY high), and then the output signal U/L (RAS/DLY low), one obtains ADD7 as a line selection signal and column selection signal, respectively, as an eighth line address and an eighth column address, respectively. In this manner, RAS generates in a per se known manner the first seven line addresses; RAS/DLY high

0154798

generates the eighth line address, which is SEL1; RAS/DLY low generates the eighth column address, which is U/L.

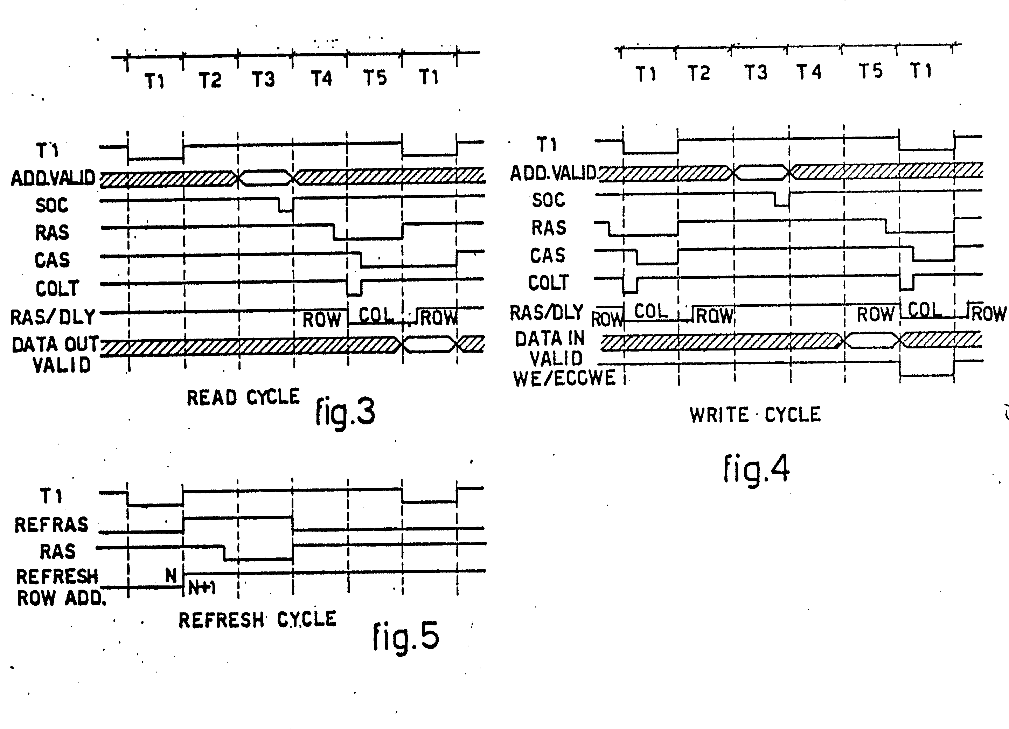

Shown in figs. 3, 4 and 5 is the development of the various signals in timed relation.

In particular, fig. 3 illustrates the reading cycle. The transition of RAS from high to low (interval T4) results in the first seven line addresses, and simultaneously the eighth address supplied by the circuit. The transition of CAS from high to low (interval T5) results in the successive seven column addresses, and simultaneously, the eighth address supplied by the circuit.

An analogous mode of operation is shown for the writing cycle illustrated in fig. 4.

Fig. 5 finally shows the per se known memory updating cycle.

GRÜNECKER. KINKELDEY. STOCKMAIR & PARTNER

PATENTANWÄLTE
EUROPEAN PATENT ATTORNEYS

A GRÜNECKER DIPL ING
DR H KINKELDEY DIPL ING
DR W STOCKMAIR DIPL ING AE E IC A TECH
DR K SCHUMANN DIPL PHYS
P H JAKOB DIPL ING
DR G BEZOLD DIPL CHEM
W MEISTER DIPL ING
H HILGERS DIPL ING
DR H MEYER-PLATH DIPL ING
DR M BOTT-BODENHAUSEN DIPL PHYS
DR U KINKELDEY DIPL BOL

*LICENCIE EN DROIT DE L UNIV DE GENEVE

8000 MÜNCHEN 22
MAXIMILIANSTRASSE 58

-1-

EP 2214-40/dg

# MEMORY CHIP FOR HANDLING MEMORY COMPONENTS

## Patent Claims

1. A memory chip, particularly, but not exclusively, a memory chip for electronic component testing systems, said chip having a capacity of 64 K words of 24 data bits and 6 memory error correction bits, and comprising a main memory bank, an error correction memory bank (ECC), an internal logic/memory timing buffer for handling signals provenient from the CPU, an address buffer, and a data I/O buffer, characterized in that said internal logic/memory timing buffer comprises a section (MPX) generating a supplementary address (ADD7) which is supplied to the address buffer for handling 64 K x 1 bit memory components via an address bus adapted for 16 K components, sais chip presenting 64 K x 1 bit memory components.

2. A memory chip according to claim 1, characterized in that said section (MPX) generating said supplementary address (ADD7) is a multiplexer (MPX).

3. A memory chip according to claims 1 and 2, characterized in that said multiplexer (MPX) is controlled by a signal (RAS/DLY) obtained by delaying (DL) a line access selection signal (RAS) supplied by the CPU.

4. A memory chip according to claims 1 and 2 or 3, characterized in that said multiplexer (MPX) presents at its input a chip selection signal (SEL1) and a signal (U/L) originarily serving for the selection of the memory bank, said signals being supplied by the CPU.

5. A memory chip according to claims 1 and 4, characterized in that said multiplexer (MPX) presents at its output, imposed on said supplementary address (ADD7), the chip selection signal (SEL1) having the significance of the line address, and the bank selection signal (U/L) having the significance of the column address.

SYSTEM | MEMORY BOARD

ECCW

ECCWE

DATA BUS

DATA I/O BUFFER

DATA OUT BUS

DATA IN BUS

MSEL

ECC MEMORY BANK

ADDRESS BUS

ADDRESS BUFFER

ADDRESS BUS

ADD7

MAIN MEMORY BANK

RAS

CAS

WE

REFRAS

U/L

SEL 1

SEL 2

INTERNAL LOGIC / MEMORY TIMING BUFFER

RAS

CAS

W

fig.1

fig.2

READ CYCLE **fig.3**

WRITE CYCLE **fig.4**

REFRESH CYCLE **fig.5**

0154798

European Patent
Office

EUROPEAN SEARCH REPORT

Application number

EP  85 10 1075

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 200 919 (PAGE et al.) <br> * Figures 1,2; column 3, line 45 - column 4, line 63 * | 1 | G 06 F   12/06 <br> G 11 C    8/00 |
| A |  | 4 | |
| Y | EP-A-0 080 902 (FUJITSU) <br> * Figure 3; page 5, lines 17-34 * | 1 | |
| Y | GB-A-2 091 008 (HITACHI) <br> * Figures 1,4,10; page 1, line 108 - page 2, line 28; page 2, lines 99-111; page 3, lines 13-26, 52-60 * | 1 | |
| A | PATENTS ABSTRACTS OF JAPAN, vol. 6, no. 171 (P-140) [1049], September 1982, & JP - A - 57 89 146 (TOKYO SHIBAURA DENKI K.K.) 03-06-1982 <br> * The whole document * | 1 | **TECHNICAL FIELDS SEARCHED (Int. Cl.4)** <br><br> G 06 F   12/06 <br> G 11 C    8/00 |
| A | IBM TECHNICAL DISCLOSURE BULLETIN, vol. 15, no. 10, March 1973, pages 3050-3051, New York, US; B.E. PHELPS: "Addressing combined memories" <br> * The whole document * | 1 | |

The present search report has been drawn up for all claims

| Place of search | Date of completion of the search | Examiner |
|---|---|---|
| THE HAGUE | 10-06-1985 | LEDRUT P. |